# EUROPEAN PATENT SPECIFICATION

(11) **EP 2 337 036 B1**
(45) Date of publication and mention of the grant of the patent: **20.02.2013**
(21) Application number: 10195327.1
(22) Date of filing: 16.12.2010
(51) Int. Cl.: H01B 1/22, H01L 31/0224

(54) **Conductive paste for solar cell electrode and solar cell using the same**
Leitfähige Paste für Solarzellenelektrode und Solarzelle damit
Pâte conductrice pour électrode de cellule solaire et cellule solaire l'utilisant

(30) Priority: 17.12.2009 KR 20090126390
(43) Date of publication of application: 22.06.2011
(73) Proprietor: CHEIL INDUSTRIES INC., Gumi-si, Gyeongsangbuk-do 730-710 (KR)
(72) Inventor: Kim, Dong Jun, Gyeonggi-do (KR); Oh, Jae Hwan, Gyeonggi-do (KR); Jung, Seok Hyun, Gyeonggi-do (KR); Lee, Byung Chul, Gyeonggi-do (KR); Nam, Hee In, Gyeonggi-do (KR)
(74) Representative: Michalski Hüttermann & Partner Patentanwälte

(56) References cited:
- EP-A2- 1 713 091
- US-A- 5 645 765
- US-A1- 2004 245 507
- US-A1- 2009 104 457
- US-A1- 2009 120 490

## Description

### BACKGROUND OF THE INVENTION

### 1. Field of the Invention

The present invention relates to a paste for solar cell electrodes and solar cells using the same. More particularly, the present invention relates to a paste for solar cell electrodes, which includes conductive particles, a glass frit, an organic vehicle and lead oxide, and electrodes and solar cells using the same.

### 2. Description of the Related Art

As fossil fuels such as oil and coal are expected to be exhausted, solar cells utilizing sunlight as an alternative energy source have attracted attention. A solar cell is formed to generate electric energy using the photovoltaic effect of a p-n junction which converts photons of sunlight into electricity. In the solar cell, a front electrode and a rear electrode are formed on a front surface and a rear surface of a semiconductor wafer or a substrate with the p-n junction, respectively. Then, the photovoltaic effect of the p-n junction is induced by sunlight entering the wafer and electrons generated by the photovoltaic effect of the p-n junction provide an electric current flowing to the outside through the electrodes.

The electrodes of the solar cell are formed on the wafer by applying, patterning, and firing a paste for an electrode. The paste for the electrode of the solar cell, particularly, for a front electrode facing an incident direction of sunlight, includes conductive particles, e.g., silver (Ag) particles, a glass frit powder, and a vehicle acting as a liquid carrier.

In recent years, solutions using lead-free glass frit powder such as Bi-based glass frits have been sought in consideration of environmental security. However, a paste for an electrode containing the lead-free glass frit powder has relatively weak contact resistance between the electrode and a semiconductor substrate.

In consideration of such a problem, the inventors of the present invention developed a paste for solar cell electrodes, which improves photoelectric efficiency and contact resistance, and electrodes and solar cells using the same.

### SUMMARY OF THE INVENTION

In accordance with an aspect of the present invention, a paste for solar cell electrodes is provided. The paste for solar cell electrodes includes (a) conductive particles, (b) a lead free glass frit, (c) an organic vehicle, and (d) lead oxide (PbO), wherein the lead oxide is added in an amount of ≥ 0.1 to ≤ 1.0 wt% with respect to a total weight of the paste.

In one embodiment, the conductive particles (a) may include at least one selected from the group consisting of silver (Ag), gold (Au), palladium (Pd), platinum (Pt), copper (Cu), chromium (Cr), cobalt (Co), aluminum (Al), tin (Sn), lead (Pb), zinc (Zn), iron (Fe), iridium (Ir), osmium (Os), rhodium (Rh), tungsten (W), molybdenum (Mo), nickel (Ni), and indium tin oxide (ITO).

The glass frit (b) is a lead-free glass frit. In one embodiment, the glass frit (b) may be a bismuth-based glass frit.

In one embodiment, the lead oxide (d) may have an average particle diameter (D₅₀) in the range of ≥ 0.1 to ≤ 25 µm.

In one embodiment, the paste for solar cell electrodes may include (a) ≥ 60 to ≤ 90 wt% of the conductive particles, (b) ≥ 0.5 to ≤ 20 wt% of the glass frit, (c) ≥ 1 to ≤ 30 wt% of the organic vehicle, and (d) ≥ 0.005 to ≤ 1.5 wt% of the lead oxide (PbO).

In another embodiment, the paste for solar cell electrodes may further include zinc oxide, bismuth oxide, or a mixture thereof. The zinc oxide, the bismuth oxide, or the mixture thereof may be added in an amount of ≥ 1 to ≤ 10 wt% to the paste.

In one embodiment, the organic vehicle (c) may include an organic binder and a solvent. The organic vehicle (c) may include ≥ 5 to ≤ 40 wt% of the organic binder and ≥ 60 to ≤ 95 wt% of the solvent.

In accordance with another aspect of the present invention, an electrode formed of the paste is provided. In one embodiment, the electrode may be formed by firing the paste and may include: (a) conductive particles, (b) a glass frit, (c) an organic vehicle, and (d) lead oxide (PbO).

In accordance with a further aspect of the present invention, a solar cell including the electrode is provided. In one embodiment, the solar cell may include a front electrode and/or a rear electrode which is an electrode using the paste.

### BRIEF DESCRIPTION OF THE DRAWING

The above and other objects, features and advantages of the present invention will become apparent from the following description of embodiments given in conjunction with the accompanying drawing, in which:

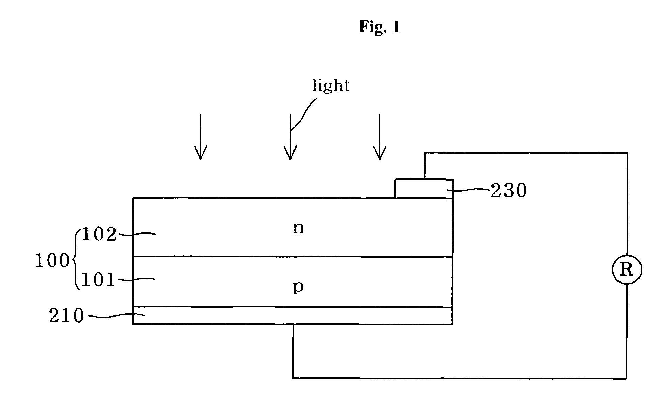

Fig. 1 is a view of a solar cell according to one embodiment of the present invention.

### DETAILED DESCRIPTION OF THE INVENTION

Embodiments of the invention will now be described in detail with reference to the accompanying drawing.

According to this invention, lead oxide (PbO) is added in an amount of ≥ 0.1 to ≤ 1.0% by weight to a paste for solar cell electrodes which includes conductive particles, a glass frit and an organic vehicle, thereby achieving an improvement in contact resistance of the electrodes and enhancement in efficiency of a solar cell. The paste for solar cell electrodes may be used to form a front electrode of a solar cell facing an incident direction of sunlight and/or a rear electrode of the solar cell facing the front electrode.

### (a) Conductive particles

According to this invention, the conductive particles may include a conductive organic material, a conductive inorganic material, or a mixture thereof.

In one embodiment, the conductive particles are inorganic particles, preferably metal particles. Examples of the conductive particles may include, but are not limited to, silver (Ag), gold (Au), palladium (Pd), platinum (Pt), copper (Cu), chromium (Cr), cobalt (Co), aluminum (Al), tin (Sn), lead (Pb), zinc (Zn), iron (Fe), iridium (Ir), osmium (Os), rhodium (Rh), tungsten (W), molybdenum (Mo), nickel (Ni), and indium tin oxide (ITO). These metals may be used alone or in an alloy of two or more kinds thereof. These conductive particles may be used alone or in a mixture of two or more kinds thereof.

In one embodiment, the conductive particles include silver (Ag) particles and may further include nickel (Ni), cobalt (Co), iron (Fe), zinc (Zn) or copper (Cu) particles.

In another embodiment, the conductive particles may include silver (Ag) and aluminum particles.

The conductive particles may have a spherical, a flake shape, an amorphous shape, or a combination thereof. In one embodiment, the conductive particles having a spherical shape may be prepared to improve a filling ratio and UV transmittance.

The conductive particle may have an average particle diameter (D₅₀) of ≥ 0.1 to ≤ 10 µm, preferably ≥ 0.2 to ≤ 7 µm, more preferably ≥ 0.5 to ≤ 5 µm, and still more preferably ≥ 1 to ≤ 3 µm.

The conductive particles may be added in an amount of ≥ 60 to ≤ 90 wt% with respect to a total weight of the paste. Within the range, discharge voltage may be minimized, short circuit of an electrode does not occur, and the paste is easily formed. The conductive particles may be added preferably in an amount of ≥ 70 to ≤ 85 wt%, and more preferably in an amount of ≥ 75 to ≤ 82 wt%.

### (b) Glass frit

The glass frit can enhance adhesion between conductive particles and a substrate in a firing process and softens in sintering, thereby lowering a firing temperature.

In this invention, the glass frit may be a lead-free glass frit. Here, the lead-free glass frit means a glass frit which contains essentially no lead. In one embodiment, the lead-free glass frit may be a glass frit that contains less than ≤ 0.005 wt% of lead.

In one embodiment, the glass frit may be a bismuth (Bi)-based glass frit that contains bismuth oxide (Bi₂O₃) as a main ingredient and further includes barium carbonate (BaCO₃), boron oxide (B₂O₃), zinc oxide (ZnO), and the like.

Examples of the lead-free glass frit may include, but are not limited to, zinc oxide-silicon oxide (ZnO-SiO₂), zinc oxide-boron oxide-silicon oxide (ZnO-B₂O₃-SiO₂), zinc oxide-boron oxide-silicon oxide-aluminum oxide (ZnO-B₂O₃-SiO₂-Al₂O₃), bismuth oxide-silicon oxide (Bi₂O₃-SiO₂), bismuth oxide-boron oxide-silicon oxide (Bi₂O₃-B₂O₃-SiO₂), bismuth oxide-boron oxide-silicon oxide-aluminum oxide (Bi₂O₃-B₂O₃-SiO₂-Al₂O₃), bismuth oxide-zinc oxide-boron oxide-silicon oxide (Bi₂O₃-ZnO-B₂O₃-SiO₂), and bismuth oxide-zinc oxide-boron oxide-silicon oxide-aluminum oxide (Bi₂O₃-ZnO- B₂O₃-S₁O₂-Al₂O₃) glass frit.

In one embodiment, the glass frit may have a softening point of ≥ 300 to ≤ 600°C, and preferably ≥ 400 to ≤ 550°C.

The glass frit may have an average particle diameter (D₅₀) of ≥ 0.1 to ≤ 5 µm. Within the range, curing of a deep part through UV irradiation is not interrupted and generation of pinholes does not occur in a developing process when forming electrodes.

The glass frit may be added in an amount of ≥ 0.5 to ≤ 20 wt% with respect to ≤ a total weight of the paste. Within the range, adhesion between the conductive particles and the substrate is good, and the firing process is carried out without any trouble. The glass frit may be added preferably in an amount of ≥ 1 to ≤ 10 wt%, and more preferably ≥ 1 to ≤ 5 wt%. In one embodiment, the glass frit may be added in an amount of ≥ 1 to ≤ 3wt%.

### (c) Organic vehicle

The organic vehicle may be an organic binder which provides liquid properties to the paste and may further include a solvent. In one embodiment, the organic vehicle (c) may be formed of an organic binder and a solvent. In another embodiment, the organic vehicle (c) may include ≥ 5 to ≤ 40 wt% of the organic binder and ≥ 60 to ≤ 95 wt% of the solvent.

As the organic binder, acrylic polymers obtained by copolymerization of acrylic monomers with a hydrophilic group, such as a carboxyl group, may be used. Furthermore, cellulose polymers, such as ethyl cellulose, hydroxyethyl cellulose, hydroxypropyl cellulose, and hydroxyethyl hydroxypropyl cellulose, may be used alone or in a mixture of two or more kinds thereof.

The solvent may be an organic solvent having a boiling point of 120□ or more. Examples of the solvent may include, but are not limited to, methyl cellosolve, ethyl cellosolve, butyl cellosolve, aliphatic alcohol, butyl carbitol acetate (BCA), α-terpineol, β-terpineol, dihydro-terpineol, ethylene glycol, ethylene glycol mono butyl ether, butyl cellosolve acetate, and texanol. These materials may be used alone or in a mixture of two or more kinds thereof.

The organic vehicle may be added in an amount of ≥ 1 to ≤ 30 wt% with respect to a total weight of the paste, preferably ≥1 to ≤ 5 wt%, and more preferably ≥ 5 to ≤ 20 wt%. Within the range, good adhesion and contact resistance may be achieved.

### (d) Lead oxide (PbO)

The present invention includes lead oxide (PbO) powder to improve contact resistance of the electrode and efficiency of the solar cell.

The lead oxide (PbO) may have an average particle diameter (D₅₀) of ≥ 0.1 to ≤ 25 µm, and more advantageously ≥ 1.5 to ≤ 15 µm. Further, triplumbic tetroxide (lead tetroxide: Pb304) powder may also added along with the lead oxide.

The lead oxide (PbO) may be added in an amount of ≥ 0.1 to ≤ 1.0 wt% with respect to a total weight of the paste, preferably ≥ 0.15 to ≤ 0.6 wt%.

### (e) Inorganic additives

The paste for solar cell electrodes may further include other inorganic additives in addition to the lead oxide (PbO). In one embodiment, zinc oxide (ZnO) powder, bismuth oxide (Bi₂O₃) powder, or a mixture thereof may be used.

The inorganic additive may have an average particle diameter (D₅₀) of ≥ 0.01 to ≤ 30 µm, more preferably ≥ 0.1 to ≤ 15 µm, and still more preferably ≥ 1 to ≤ 10 µm.

In one embodiment, the inorganic additive may be added in an amount of ≥ 1 to ≤ 10 wt% with respect to a total weight of the paste, preferably ≥ 2 to ≤ 7 wt%, and more preferably ≥ 3 to ≤ 5 wt%. Within the range, good contact resistance may be achieved.

The paste for solar cell electrodes may further include general additives, as needed, to enhance flow properties, process properties, and stability. The additives may include, but are not limited to, a plasticizer, a dispersant, a thixotropic agent, a viscosity stabilizer, an anti-foaming agent, a pigment, a UV stabilizer, an antioxidant, a coupling agent, etc. These additives may be used alone or in a mixture of two or more kinds thereof. These additives are well known to those skilled in the art and are commercially available.

Other aspects of the invention provide electrodes formed of the paste for solar cell electrodes and a solar cell including the electrodes. Fig. 1 shows a solar cell according to one embodiment of the present invention.

Referring to Fig. 1, a rear electrode 210 and a front electrode 230 may be formed by printing and firing the paste on a wafer or substrate 100 that includes a p-layer 101 and an n-layer 102, which will serve as an emitter. For example, a preliminary process for preparing the rear electrode 210 is performed by printing the paste for electrodes on a rear surface of the wafer 100 and drying the printed paste at ≥ 200 to ≤ 400°C for ≥ 0 to ≤ 60 seconds. Further, a preliminary process for preparing the front electrode 230 may be performed by printing the paste on a front surface of the wafer 100 and drying the printed paste. Then, the front electrode 230 and the rear electrode 210 may be formed by firing the wafer 100 at ≥ 400 to ≤ 900°C for ≥ 30 to ≤ 50 seconds. The wafer may be formed of polycrystalline silicon and may include not only a multi-wafer having bent shapes formed by grains on the surface thereof, but also a mono-wafer.

Next, the present invention will be described in detail with reference to examples. However, it should be noted that these examples are provided for illustrative purposes and do not limit the scope of the invention.

Details can be technically deduced by any person skilled in the art, and thus, a description thereof will be omitted.

### Examples

Specifications of ingredients used in the following examples and comparative examples are as follows:
(a) Conductive particles: 4-11F (Ag powder, Dowa Holding Co., Ltd.)
(b) Glass frit: lead-free glass frit, 55C-2 (Bi containing glass, PDE Co., Ltd.)
(b') Glass frit: lead glass frit containing lead oxide, 55C-2 (PDE Co., Ltd.)
(c) Organic vehicle: STD20 (10 wt% of a solid cellulose polymer, 27 wt% BCA, and 63 wt% terpineol, Dow Chemical Co., Ltd.)
(d) Lead oxide (PbO): powder having an average particle diameter (D₅₀) of 10 µm (PDE Co., Ltd.)
(e) Inorganic additives: zinc oxide (ZnO) powder having an average particle diameter (D50) of 2 µm (Kanto Chemical Co., Ltd.)

### Examples 1 to 4

The aforementioned ingredients were added at a ratio given in Table 1 and mixed by a C-mixer for 100 seconds, followed by milling by a 3-roll mill, thereby preparing pastes for solar cell electrodes. In Examples 1 to 4, the conductive particles, the glass frit, and the inorganic additive were fixed in amount, and the content of PbO was split-changed.

### Comparative Example 1

Comparative Example 1 was carried out by the same process as in Example 1 except for use of lead oxide.

### Comparative Example 2

Comparative Example 2 was carried out by the same process as in Example 1 except that lead oxide was not used but a lead glass frit (b') was used.

### Comparative Example 3

Comparative Example 3 was carried out by the same process as in Example 1 except that lead oxide was used at 2 wt%.

Each of the pastes prepared in Examples 1 to 4 and Comparative Examples 1 and 2 was applied to a rear surface and a front surface of a 5-inch multi-wafer and dried at 300□ for ≥ 20 to ≤ 40 seconds, thereby completing a preliminary process for a rear electrode 210 and a front electrode 230. Then, the wafer was fired at a peak temperature of ≥ 755 to ≤ 800°C for ≥ 2 to ≤ 5 seconds to form the front electrode 230 and the rear electrode 210. Next, the electrodes 210 and 230 were measured in resistance (series resistance, mΩ) and induced photoelectric efficiency by a tester (CT801, Pasan SA). The results are shown in Table 1.

**[Table 1]**

| | Example 1 | Example 2 | Example 3 | Example 4 | Comparative Example 1 | Comparative Example 2 | Comparative Example 3 |
|---|---|---|---|---|---|---|---|
| (a) | 79 | 79 | 79 | 79 | 79 | 79 | 79 |
| (b) | 1.12 | 1.12 | 1.12 | 1.12 | 1.12 | - | 1.12 |
| (b') | - | - | - | - | - | 1.32 | - |
| (c) | 16.16 | 15.86 | 15.66 | 15.36 | 16.36 | 16.16 | 17.96 |
| (d) | 0.2 | 0.5 | 0.7 | 1.0 | - | - | 2 |
| (e) | 3.52 | 3.52 | 3.52 | 3.52 | 3.52 | 3.52 | 3.52 |
| Rs (mΩ) | 9.8 | 9.9 | 11.4 | 11.7 | 17.7 | 13.1 | 16.8 |
| Efficiency (%) | 15.19 | 14.85 | 13.75 | 13.66 | 13.83 | 13.67 | 12.64 |

| | | | | | | | |
|---|---|---|---|---|---|---|---|
| Unit: wt% | | | | | | | |

As shown in Table 1, Examples 1 to 4 in which lead oxide is added separately exhibit good efficiency and improvement in contact resistance, as compared with Comparative examples 1 and 2. Here, since a small amount of PbO is added, environmental problems associated with lead may be substantially eliminated. Further, when PbO is present at 1.5 wt% or less with respect to the total weight of the paste, enhancement in properties is effective. In particular, when PbO is in the range of ≥ 0.2 to ≤ 0.5 wt%, remarkable improvement in contact resistance and efficiency is realized.

## Claims

1. A paste for solar cell electrodes, comprising:
(a) conductive particles;
(b) a lead free glass frit;
(c) an organic vehicle; and
(d) lead oxide (PbO),
wherein said lead oxide being added in an amount of ≥ 0.1 wt.-% to ≤ 1 wt.-% with respect to a total weight of the paste.

2. The paste for solar cell electrodes according to claim 1, wherein said conductive particles (a) comprise at least one selected from the group consisting of silver (Ag), gold (Au), palladium (Pd), platinum (Pt), copper (Cu), chromium (Cr), cobalt (Co), aluminum (Al), tin (Sn), lead (Pb), zinc (Zn), iron (Fe), iridium (Ir), osmium (Os), rhodium (Rh), tungsten (W), molybdenum (Mo), nickel (Ni), and indium tin oxide (ITO).

3. The paste for solar cell electrodes according to claims I and 2, wherein said glass frit (b) is a bismuth-based glass frit.

4. The paste for solar cell electrodes according to claims 1 to 3, wherein said lead oxide (d) has an average particle diameter (D₅₀) in the range of ≥ 0.1 to ≤ 25 µm

5. The paste for solar cell electrodes according to claims 1 to 4, wherein said paste comprises (a) ≥ 60 to ≤ 90 wt% of the conductive particles, (b) ≥ 0.5 to ≤ 20 wt% of the glass frit, (c) ≥ 1 to ≤ 30 wt% of the organic vehicle, and (d) ≥ 0.05 to ≤ 1.5 wt% of the lead oxide (PbO).

6. The paste for solar cell electrodes according to claims 1 to 5, further comprising: zinc oxide, bismuth oxide or a mixture thereof in an amount of ≥ 1 to ≤ 10 wt%.

7. The paste for solar cell electrodes according to claims 1 to 6, wherein said organic vehicle (c) comprises an organic binder and a solvent.

8. The paste for solar cell electrodes according to claims 1 to 7, wherein said organic vehicle (c) comprises ≥ 5 to ≤ 40 wt% of the organic binder and ≥ 60 to ≤ 95 wt% of the solvent.

9. A solar cell electrode formed by firing the paste according to claims 1 to 8, and comprising (a) conductive particles, (b) a glass frit, (d) lead oxide (PbO).

10. A solar cell comprising the electrode according to claim 9.

## Patentansprüche

1. Paste für Solarzellenelektroden, umfassend:
(a) leitfähige Partikel;
(b) eine bleifreie Glasmasse;
(c) ein organisches Vehikel und
(d) Bleioxid (PbO),
wobei das Bleioxid in einer Menge von ≥ 0,1 Gew.-% bis ≤ 1 Gew.-%, bezogen auf das Gesamtgewicht der Paste, zugesetzt ist.

2. Paste für Solarzellenelektroden nach Anspruch 1, wobei die leitfähigen Partikel (a) mindestens ein Mitglied der Gruppe bestehend aus Silber (Ag), Gold (Au), Palladium (Pd), Platin (Pt), Kupfer (Cu), Chrom (Cr), Cobalt (Co), Aluminium (Al), Zinn (Sn), Blei (Pb), Zink (Zn), Eisen (Fe), Iridium (Ir), Osmium (Os), Rhodium (Rh), Wolfram (W), Molybdän (Mo), Nickel (Ni) und Indiumzinnoxid (ITO) umfassen.

3. Paste für Solarzellenelektroden nach den Ansprüchen 1 und 2, wobei es sich bei der Glasmasse (b) um eine auf Bismut basierende Glasmasse handelt.

4. Paste für Solarzellenelektroden nach den Ansprüchen 1 bis 3, wobei das Bleioxid (d) einen mittleren Teilchendurchmesser (D₅₀) im Bereich von ≥ 0,1 bis ≤ 25 µm aufweist.

5. Paste für Solarzellenelektroden nach den Ansprüchen 1 bis 4, wobei die Paste (a) ≥ 60 bis ≤ 90 Gew.-% der leitfähigen Partikel, (b) ≥ 0,5 bis ≤ 20 Gew.-% der Glasmasse, (c) ≥ 1 bis ≤ 30 Gew.-% des organischen Vehikels und (d) ≥ 0,05 bis ≤ 1,5 Gew.-% des Bleioxids (PbO) umfasst.

6. Paste für Solarzellenelektroden nach den Ansprüchen 1 bis 5, ferner umfassend: Zinkoxid, Bismutoxid oder eine Mischung davon in einer Menge von ≥ 1 bis ≤ 10 Gew.-%.

7. Paste für Solarzellenelektroden nach den Ansprüchen 1 bis 6, wobei das organische Vehikel (c) ein organisches Bindemittel und ein Lösungsmittel umfasst.

8. Paste für Solarzellenelektroden nach den Ansprüchen 1 bis 7, wobei das organische Vehikel (c) ≥ 5 bis ≤ 40 Gew.-% des organischen Bindemittels und ≥ 60 bis ≤ 95 Gew.-% des Lösungsmittels umfasst.

9. Solarzellenelektrode, gebildet durch Brennen der Paste nach einem der Ansprüche 1 bis 8 und umfassend (a) leitfähige Partikel, (b) eine Glasmasse, (d) Bleioxid (PbO).

10. Solarzelle mit der Elektrode nach Anspruch 9.

## Revendications

1. Pâte pour électrodes de cellules solaires, comprenant :
(a) des particules conductrices ;
(b) de la fritte de verre sans plomb :
(c) un véhicule organique ; et
(d) de l'oxyde de plomb (PbO),
dans laquelle ledit oxyde de plomb est ajouté dans une quantité de ≥ 0,1 % en poids à ≤ 1 % en poids par rapport au poids total de la pâte.

2. Pâte pour électrodes de cellules solaires selon la revendication 1, dans laquelle lesdites particules conductrices (a) comprennent au moins un élément choisi dans le groupe constitué par l'argent (Ag), l'or (Au), le palladium (Pd), le platine (Pt), le cuivre (Cu), le chrome (Cr), le cobalt (Co), l'aluminium (Al), l'étain (Sn), le plomb (Pb), le zinc (Zn), le fer (Fe), l'iridium (Ir), l'osmium (Os), le rhodium (Rh), le tungstène (W), le molybdène (Mo), le nickel (Ni), et l'oxyde d'indium-étain (ITO).

3. Pâte pour électrodes de cellules solaires selon les revendications 1 et 2, dans laquelle ladite fritte de verre (b) est une fritte de verre à base de bismuth.

4. Pâte pour électrodes de cellules solaires selon les revendications 1 à 3, dans laquelle ledit oxyde de plomb (d) a un diamètre moyen de particules (D₅₀) dans la gamme de ≥ 0,1 à ≤ 25 µm.

5. Pâte pour électrodes de cellules solaires selon les revendications 1 à 4, ladite pâte comprenant (a) ≥ 60 à ≤ 90 % en poids des particules conductrices, (b) ≥ 0,5 à ≤ 20 % en poids de la fritte de verre, (c) ≥ 1 à ≤ 30 % en poids du véhicule organique, et (d) ≥ 0,05 à ≤ 1,5 % en poids de l'oxyde de plomb (PbO).

6. Pâte pour électrodes de cellules solaires selon les revendications 1 à 5, comprenant en outre de l'oxyde de zinc, de l'oxyde de bismuth ou un mélange de ceux-ci dans une quantité de ≥ 1 à ≤ 10 % en poids.

7. Pâte pour électrodes de cellules solaires selon les revendications 1 à 6, dans laquelle ledit véhicule organique (c) comprend un liant organique et un solvant.

8. Pâte pour électrodes de cellules solaires selon les revendications 1 à 7, dans laquelle ledit véhicule organique (c) comprend ≥ 5 à ≤ 40 % en poids du liant organique et ≥ 60 à ≤ 95 % en poids du solvant.

9. Electrode de cellule solaire formée en cuisant la pâte selon les revendications 1 à 8, et comprenant (a) des particules conductrices, (b) de la fritte de verre, (d) de l'oxyde de plomb (PbO).

10. Cellule solaire comprenant l'électrode selon la revendication 9.
